(19) Europäisches Patentamt / European Patent Office / Office européen des brevets

(11) **EP 4 484 971 B1**

(12) **EUROPÄISCHE PATENTSCHRIFT**

(45) Veröffentlichungstag und Bekanntmachung des Hinweises auf die Patenterteilung:
**10.12.2025 Patentblatt 2025/50**

(21) Anmeldenummer: **24183323.5**

(22) Anmeldetag: **20.06.2024**

(51) Internationale Patentklassifikation (IPC):
**G01R 27/02** *(2006.01)*

(52) Gemeinsame Patentklassifikation (CPC):
**G01R 27/025**; G01R 31/52

(54) **VERFAHREN ZUR BERECHNUNG EINES ISOLATIONSWIDERSTANDS IN EINEM UNGEERDETEN DC-STROMVERSORGUNGSSYSTEM BEI VERÄNDERLICHER DC-NETZSPANNUNG**

METHOD FOR CALCULATING AN INSULATION RESISTANCE IN AN UNGROUNDED DC POWER SUPPLY SYSTEM WHEN THE DC NETWORK VOLTAGE IS VARIABLE

PROCÉDÉ DE CALCUL D'UNE RÉSISTANCE D'ISOLATION DANS UN SYSTÈME D'ALIMENTATION EN COURANT CONTINU NON MIS À LA TERRE À TENSION DE RÉSEAU CC VARIABLE

(84) Benannte Vertragsstaaten:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorität: **28.06.2023 DE 102023117040**

(43) Veröffentlichungstag der Anmeldung:
**01.01.2025 Patentblatt 2025/01**

(73) Patentinhaber: **Bender GmbH & Co. KG**
**35305 Grünberg (DE)**

(72) Erfinder: **MACHT, Burkhard**
**35410 Hungen (DE)**

(74) Vertreter: **advotec.**
**Patent- und Rechtsanwaltspartnerschaft mbB**
**Georg-Schlosser-Straße 6**
**35390 Gießen (DE)**

(56) Entgegenhaltungen:
DE-A1- 102015 102 310 DE-B4- 102014 205 877
JP-B2- 6 220 821 US-A1- 2018 154 776

**Beschreibung**

Die Erfindung betrifft ein Verfahren zur Berechnung eines Isolationswiderstands in einem ungeerdeten DC-Stromversorgungssystem bei veränderlicher DC-Netzspannung.

Die Netzform eines ungeerdeten Stromversorgungssystems, die auch als isoliertes Netz (isolé terre - IT) oder als IT-(Stromversorgungs-)System bezeichnet wird, kommt bei erhöhten Anforderungen an die Betriebs-, Brand- und Berührungssicherheit elektrischer Anlagen zum Einsatz. Bei dieser Art des Stromversorgungssystems sind die aktiven Teile von dem Erdpotential - gegenüber Erde - getrennt. Der Vorteil dieser Netze liegt darin, dass bei einem Isolationsfehler, wie beispielsweise einem Erdschluss oder einem Körperschluss, die Funktion der angeschlossenen elektrischen Verbraucher nicht beeinträchtigt wird, da sich wegen des im Idealfall unendlich großen Impedanzwertes zwischen einem aktiven Leiter des Netzes und Erde kein geschlossener Stromkreis ausbilden kann.

Durch diese inhärente Sicherheit des ungeerdeten Stromversorgungssystems kann somit eine kontinuierliche Stromversorgung der von dem ungeerdeten Stromversorgungssystem gespeisten Verbraucher auch dann gewährleistet werden, wenn ein erster Isolationsfehler auftritt.

Der Widerstand des ungeerdeten Stromversorgungssystems gegen Erde (Isolationswiderstand - im Fehlerfall auch Isolationsfehlerwiderstand oder Fehlerwiderstand) wird daher ständig überwacht, da durch einen möglichen weiteren Fehler an einem anderen aktiven Leiter eine Fehlerschleife entstünde und der dabei fließende Fehlerstrom in Verbindung mit einer Überstromschutzeinrichtung eine Abschaltung der Anlage mit Betriebsstillstand zur Folge hätte.

Unter der Voraussetzung, dass der Isolationszustand des ungeerdeten Stromversorgungssystems kontinuierlich überwacht wird, kann dieses IT-System auch bei einem aufgetretenen ersten Fehler ohne vorgeschriebene Zeitlimitierung weiter betrieben werden.

Zur Überwachung des Isolationswiderstands werden Isolationsüberwachungsgeräte eingesetzt. Aus dem Stand der Technik bekannte Isolationsüberwachungsgeräte nach der Produktnorm IEC 61557-8 bestimmen den Isolationswiderstand des gesamten IT-Systems gegen Erde. Das Isolationsüberwachungsgerät wird zwischen den aktiven Leitern einerseits und Erde andererseits angeschlossen und überlagert dem Netz eine Messspannung (aktives Messverfahren). Bei Auftreten eines Isolationsfehlers schließt sich der Messkreis zwischen Netz und Erde über den Isolationsfehler, sodass sich ein von dem Isolationswiderstand abhängiger Messstrom einstellt. Dieser Messstrom verursacht an einem Messwiderstand eines Messpfads in dem Isolationsüberwachungsgerät einen entsprechenden Spannungsabfall, der von der Elektronik ausgewertet wird und bei Überschreiten eines voreinstellbaren Grenzwertes zu einer Alarmmeldung führt.

Ein derartiges, in einem DC-Stromversorgungssystem installiertes, normgemäßes Isolationsüberwachungsgerät wird als Systemumgebung für das erfindungsgemäße Verfahren zur Bestimmung des Isolationswiderstands vorausgesetzt. Das betrachtete Isolationsüberwachungsgerät weist in zweipoliger Ankopplung zwischen jeweils einem der aktiven Leiter des DC-Stromversorgungssystems gegen Erde einen Messpfad auf, der eine Reihenschaltung mit einem Ankoppelwiderstand, einem Messwiderstand und einem gemeinsamen Messspannungsgenerator zum Erzeugen einer Messspannung umfasst.

Die Bestimmung des Messstroms kann allerdings durch Störeffekte verfälscht werden, da neben dem durch die Überlagerung der aktiven Messspannung getriebenen Messstrom weitere Stromanteile über den Messpfad fließen.

Um durch Fremdgleichspannungen oder große Netzableitkapazitäten verursachten Messfehlern entgegen zu wirken, ist aus dem Stand der Technik bekannt, als Messspannung statt einer Messgleichspannung eine periodische Rechteck-Messpulsspannung mit einer ersten Pulsamplitude und einer zweiten Pulsamplitude als Messsignal aufzuschalten (Impulsmessverfahren).

Auch bekannt sind Messverfahren, bei denen eine speziell getaktete Messpulsspannung mit adaptierten Messimpulsen und/oder variablen Taktzeiten zur Anwendung gelangt, um zwischen Netzableitstromanteilen, die als Störgröße auftreten, und dem von der Messpulsspannung bewirkten Messpulsstrom zu Berechnung des ohmschen Isolationswiderstands (Fehlerwiderstand) unterscheiden zu können.

In DC-Stromversorgungssystemen allerdings kann auch die Messung mit adaptiven Messimpulsen zu Fehlmessungen führen, falls sich die DC-Netzspannung zwischen zwei eingeschwungenen Zuständen ändert.

Der in dem Gesamtmessstrom enthaltene, durch die DC-Netzspannung bewirkte DC-Anteil kann dann wegen der DC-Netzspannungsänderung nicht mehr korrekt herausgerechnet werden, sodass ein Messfehler entsteht. Ein typisches Beispiel für den Fall einer Änderung der DC-Netzspannung stellt eine PV-Anlage bei Verschattung, beispielsweise durch schnell wechselnde Abschattung durch Bewölkung, dar.

Eine Maßnahme um Störeffekte durch veränderliche Betriebsspannungen zu vermeiden ist aus der Offenlegungsschrift DE 10 2014 205 877 A1 bekannt. Dort ist die Überwachung der Isolation in einem Bordnetz eines Fahrzeugs beschrieben. Die Ermittlung des Isolationswiderstands erfolgt in einer einpoligen Ankopplung über einen Strompfad, wobei der Isolationswiderstand iterativ berechnet wird und ein dimensionsloser Korrekturwert zur Korrektur einer Betriebsspannungsdifferenz in die Berechnung einfließt.

Die DE 10 2014 204 870 A1 zeigt in ähnlicher Weise die Ermittlung des Isolationswiderstands in einem Fahrzeug-Bordnetz, wobei bei unterschiedlichen Betriebsspannungen eine dritte Messung durchgeführt wird oder unter Einbeziehung eines aus einer Korrekturfaktor-Tabelle abgelesenen Korrekturfaktors eine Korrektur des Isolationswiderstands vorgenommen wird.

Relevant aus dem Stand der Technik ist auch US 2018/154776 A1. Es offenbart die Berechnung eines Isolationswiderstands in einem ungeerdeten DC-Stromversorgungssystem in einem Fahrzeug. Zur Bestimmung wird eine Rechteckspannung angelegt und ein Strom im eingeschwungenen Zustand gemessen. Hierbei kann insbesondere der Einfluss einer zeitlich fluktuierenden Batteriespannung berücksichtigt werden.

Sowohl die iterative Berechnung als auch eine dritte Messung sowie das Ablesen des Korrekturwertes aus einer Tabelle scheinen die Berechnung des Isolationswiderstands sehr komplex zu gestalten.

Der vorliegenden Erfindung liegt somit die Aufgabe zugrunde, ein Verfahren anzugeben, mit dem in einem ungeerdeten DC-Stromversorgungssystem der Isolationswiderstand bei veränderlicher DC-Netzspannung effizient und genau berechnet werden kann.

Diese Aufgabe wird in Verbindung mit den Merkmalen des Oberbegriffs in Anspruch 1 durch die im kennzeichnenden Teil des Anspruchs 1 beanspruchten Verfahrensschritte gelöst.

Dazu wird jeweils in einem eingeschwungenen Zustand der ersten Pulsamplitude sowie in einem geschwungenen Zustand der zweiten Pulsamplitude bei der jeweils aktuell vorherrschenden DC-Netzspannung ein erster und ein zweiter Gesamtmessstrom erfasst.

Der Gesamtmessstrom entspricht der Summe aus dem von der Messpulsspannung getriebenen, zu ermittelnden Messpulsstrom und dem von der DC-Netzspannung getriebenen, als Störanteil auftretenden Netzspannungsstrom.

Aus der bekannten ersten und zweiten Pulsamplitude, dem gemessenen ersten und zweiten Gesamtmessstrom sowie aus der jeweils aktuellen ersten und zweiten DC-Netzspannung wird ein Korrekturfaktor K berechnet.

Aus der Differenz des gemessenen ersten Gesamtmessstroms und der mit dem Korrekturfaktor multiplizierten aktuellen ersten DC-Netzspannung wird anschließend ein von der ersten Pulsamplitude getriebener erster Messpulsstrom berechnet.

Alternativ dazu kann in gleicher Weise ein zweiter Messpulsstrom aus der Differenz des gemessenen zweiten Gesamtmessstroms und der mit dem Korrekturfaktor multiplizierten aktuellen zweiten DC-Netzspannung berechnet werden.

Abschließend erfolgt ein Berechnen des Isolationswiderstands aus der ersten Pulsamplitude und dem ersten Messpulsstrom sowie aus den Ankoppelwiderständen und den Messwiderständen.

Alternativ dazu erfolgt die Berechnung des Isolationswiderstands aus der zweiten Pulsamplitude, dem zweiten Messpulsstrom sowie den Ankoppelwiderständen und den Messwiderständen.

In zwei aufeinanderfolgenden Messungen zum Zeitpunkt des jeweils eingeschwungenen Zustands der ersten und der zweiten Pulsamplitude wird bei veränderter DC-Netzspannung der Isolationswiderstand korrekt berechnet. Für die Berechnung werden in dem jeweiligen eingeschwungenen Zustand neben der Pulsamplitude der gemessene Gesamtmessstrom sowie die jeweils aktuelle DC-Netzspannung benötigt.

In weiterer Ausgestaltung wird der Korrekturfaktor bestimmt durch Berechnen einer Stromdifferenz aus dem mit dem Verhältnis der zweiten Pulsamplitude zu der ersten Pulsamplitude multiplizierten ersten Gesamtmessstrom und dem zweiten Gesamtmessstrom, durch Berechnen einer Spannungsdifferenz aus der mit dem Verhältnis der zweiten Pulsamplitude zu der ersten Pulsamplitude multiplizierten aktuellen ersten DC-Netzspannung und der zweiten DC-Netzspannung sowie durch Berechnen des Korrekturfaktors als Quotient aus der Stromdifferenz und der Spannungsdifferenz.

Das Berechnen des Isolationswiderstands erfolgt durch Berechnen eines Widerstands-Quotienten aus der ersten oder der zweiten Pulsamplitude und dem entsprechenden ersten oder zweiten Messpulsstrom und durch Berechnen einer Widerstands-Differenz als Isolationswiderstand aus der Differenz des Widerstands-Quotienten und einem Messpfad-Widerstand, wobei sich der Messpfad-Widerstand aus der Parallelschaltung der Reihenschaltungen des Ankoppelwiderstands und des Messwiderstands ergibt.

Die Berechnung des Isolationswiderstands kann somit entweder über die bei der ersten Messung - im eingeschwungenen Zustand der ersten Pulsamplitude - ermittelten Größen oder über die bei der zweiten Messung - im eingeschwungenen Zustand der zweiten Pulsamplitude -ermittelten Größen erfolgen.

Bevorzugt wird ein Vergleich des aus der ersten Messung berechneten Isolationswiderstands mit dem aus der zweiten Messung berechneten Isolationswiderstand durchgeführt.

Der Vergleich der beiden berechneten Isolationswiderstandswerte ermöglicht eine Aussage über die Zuverlässigkeit der Berechnung des jeweils ermittelten Wertes. Auf diese Weise kann eine Plausibilitätskontrolle erfolgen und durch Messfehler oder Störeinflüsse hervorgerufene Ausreißer können eliminiert werden.

Weitere vorteilhafte Ausgestaltungsmerkmale ergeben sich aus der nachfolgenden Beschreibung und den Zeichnungen, die eine bevorzugte Ausführungsform der Erfindung anhand von Beispielen erläutern.

Es zeigen:

Fig. 1    ein Prinzipschaltbild einer Isolationswiderstandsmessung im ungeerdeten DC-Stromversorgungssystem mit zweipoliger Ankopplung,

**Fig. 2** ein Ablaufdiagramm des erfindungsgemäßen Verfahrens und

**Fig. 3** Mess-und Simulationsergebnisse.

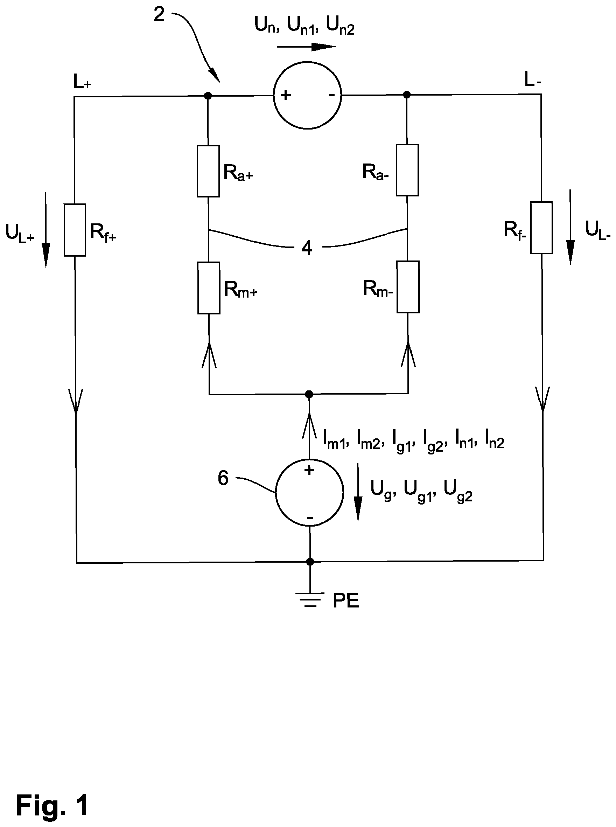

**Fig. 1** zeigt die prinzipielle Struktur einer Schaltung zur Isolationswiderstandsmessung wie sie in einem normgemäßen Isolationsüberwachungsgerät mit zweipoliger Ankopplung in einem ungeerdeten DC-Stromversorgungssystem 2 eingesetzt wird.

Das DC-Stromversorgungssystem 2 wird von einer DC-Netzspannung $U_n$ gespeist, die bedingt durch Störeinflüsse veränderlich ist und hier beispielhaft zu zwei aufeinanderfolgenden Messzeitpunkten die Spannungswerte $U_{n1}$, $U_{n2}$ annimmt.

Das DC-Stromversorgungssystem 2 weist zwei aktive Leiter $L_+$, $L_-$ auf, zwischen denen jeweils ein Isolationswiderstand $R_{f+}$, $R_{f-}$ gegen Erde PE messbar ist. Zwischen den aktiven Leitern $L_+$, $L_-$ stellt sich jeweils eine Leiter-Erde-Spannung $U_{L+}$, $U_{L-}$ ein, aus deren Messung gemäß

$$U_n = U_{L+} - U_{L-}$$

die jeweils aktuelle erste oder zweite DC-Netzspannung $U_{n1}$, $U_{n2}$ bestimmt wird.

Zwischen den aktiven Leitern $L_+$, $L_-$ und Erde ist zur Überwachung des Isolationswiderstands jeweils ein Messpfad 4 eingerichtet, der einen Ankoppelwiderstand $R_{a+}$, $R_{a-}$, einen Messwiderstand $R_{n+}$, $R_{n-}$ sowie einen gemeinsamen Messspannungsgenerator 6 zum Erzeugen einer Messpulsspannung $U_g$ mit einer ersten Pulsamplitude $U_{g1}$ und einer zweiten Pulsamplitude $U_{g2}$ aufweist.

Über beide Messpfade 4 und den gemeinsamen Messspannungsgenerator 6 fließt ein dem ersten oder dem zweiten Messzeitpunkt entsprechender erster oder zweiter Gesamtmessstrom $I_{m1}$, $I_{m2}$, der sich jeweils aus einem von der ersten oder zweiten Pulsamplitude $U_{g1}$, $U_{g2}$ getriebenen Messpulsstrom $I_{g1}$, $I_{g2}$ und einem von der DC-Netzspannung $U_{n1}$, $U_{n2}$ getriebenen, als Störstrom wirkenden, Netzspannungsstrom $I_{n1}$, $I_{n2}$ zusammensetzt.

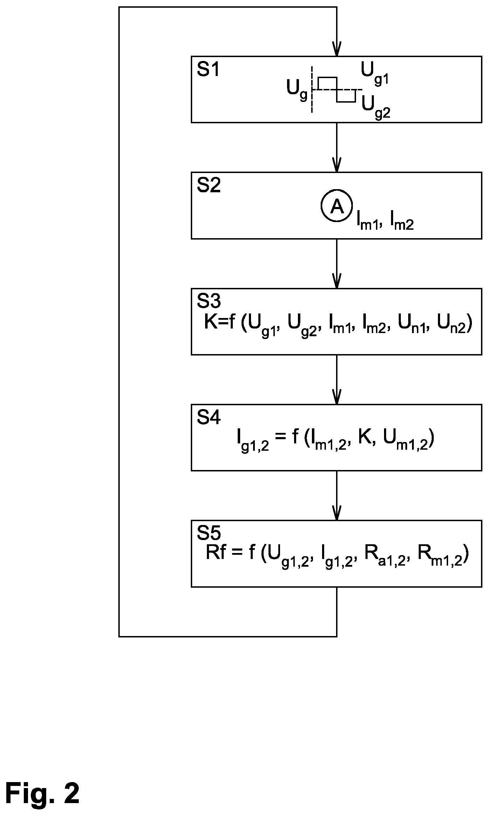

In **Fig. 2** ist ein Ablaufdiagram des erfindungsgemäßen Verfahrens dargestellt.

In Schritt S1 erfolgt zunächst ein Schalten einer periodischen Rechteck-Messimpulsspannung $U_g$ mit einer ersten Pulsamplitude $U_{g1}$ und einer zweiten Pulsamplitude $U_{g2}$.

In Schritt S2 wird jeweils in dem eingeschwungenen Zustand der ersten Pulsamplitude $U_{g1}$ und der zweiten Pulsamplitude $U_{g2}$ bei der zu diesem Messzeitpunkt jeweils aktuell vorhandenen ersten oder zweiten DC-Netzspannung $U_{n1}$, $U_{n2}$ der jeweilige Gesamtmessstrom $I_{m1}$, $I_{m2}$ gemessen.

In Schritt S3 erfolgt ein Berechnen eines Korrekturfaktors K als Quotient aus einer Stromdifferenz $I_d$ und einer Spannungsdifferenz $U_d$ gemäß

$$K = \frac{I_d}{U_d}$$

mit

$$I_d = \frac{U_{g2}}{U_{g1}} * I_{m1} - I_{m2}$$

und

$$U_d = \frac{U_{g2}}{U_{g1}} * U_{n1} - U_{n2}$$

Für symmetrische Pulsamplituden mit $U_{g1} = -U_{g2}$ lässt sich der Ausdruck zur Berechnung des Korrekturfaktors K vereinfachen zu

$$K = \frac{I_{m1} + I_{m2}}{U_{n1} + U_{n2}}$$

Der gemessene erste Gesamtmessstrom $I_{m1}$ sowie der zweite gemessene Gesamtmessstrom $I_{m2}$ setzen sich jeweils aus der von der ersten Pulsamplitude $U_{g1}$ oder der zweiten Pulsamplitude $U_{g2}$ getriebenen ersten Messpulsstrom $I_{g1}$ oder zweiten Messpulsstrom $I_{g2}$ und dem von der jeweils aktuellen ersten oder zweiten DC-Netzspannung $U_{n1}$, $U_{n2}$ getriebenen ersten oder zweiten Netzspannungsstrom $I_{n1}$ und $I_{n2}$ zusammen:

$$I_{m1} = I_{g1} + I_{n1} \iff I_{m1} = I_{g1} + K * U_{n1}$$

$$I_{m2} = I_{g2} + I_{n2} \iff I_{m2} = I_{g2} + K * U_{n2}$$

Der Korrekturfaktor K besitzt die Dimension eines Leitwerts und korrigiert somit, multipliziert mit der zugehörigen DC-Netzspannung $U_{n1}$, $U_{n2}$, in Schritt S4 den Gesamtmessstrom $I_{m1}$, $I_{m2}$, wodurch der jeweilige ausschließlich durch die Messimpulsspannung $U_g$ getriebene Messpulsstrom $I_{g1}$, $I_{g2}$ ermittelt werden kann:

$$I_{g1} = I_{m1} - K * U_{n1}$$

$$I_{g2} = I_{m2} - K * U_{n2}$$

Abschließend wird in Schritt 5 der Isolationswiderstand $R_f$ für den ersten Messzeitpunkt als $R_{f1}$ aus einer Widerstands-Differenz eines Widerstands-Quotienten $U_{g1}/I_{g1}$ und einem Messpfad-Widerstand $R_a/2$ berechnet:

$$R_{f1} = \frac{U_{g1}}{I_{g1}} - \frac{R_a}{2},$$

wobei sich der Messpfad-Widerstand $R_a/2$ mit $R_a = R_{a+} + R_{m+}$ aus der Parallelschaltung (zweipolige Ankopplung) der Reihenschaltungen (Messpfad) des jeweiligen Ankoppelwiderstands $R_{a+}$, $R_{a-}$ und des jeweiligen Messwiderstands $R_{m+}$, $R_{m-}$ ergibt.

Analog kann der Isolationswiderstand $R_f$ als $R_{f2}$ aus der zweiten Messung bestimmt werden:

$$R_{f2} = \frac{U_{g2}}{I_{g2}} - \frac{R_a}{2},$$

sodass $R_f = R_{f1} = R_{f2}$ gilt.

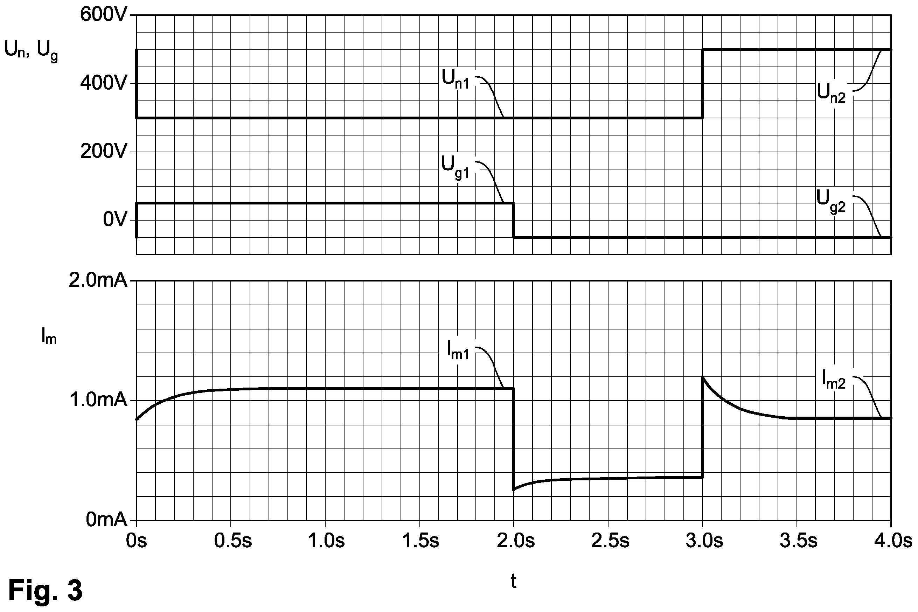

**Fig. 3** und die nachfolgenden Tabellen zeigen die Spannungs- und Stromverläufe mit der ersten und zweiten Pulsamplitude $U_{g1}$, $U_{g2}$ der Messpulsspannung $U_g$, den jeweiligen DC-Netzspannungen $U_{n1}$, $U_{n2}$ und dem gemessenen ersten Gesamtmessstrom $I_{m1}$ und zweiten Gesamtmessstrom $I_{m2}$ sowie Mess-und Simulationsergebnisse.

| DC-Netzspannung konstant: $U_{n1} = U_{n2}$ = 300 V | | | | | |
|---|---|---|---|---|---|
| $U_{n1}$/V 300 | $U_{g1}$/V 50 | $I_{m1}$/mA 1.098 | $U_{n2}$/V 300 | $U_{g2}$/V -50 | $I_{m2}$/mA 0.366 |
| K 2,43883E-06 | $I_{g1}$/mA 0.36595 | $R_{f1}$/Ω 16.6 | ODER | $I_{g2}$/mA -0.3660 | $R_{f2}$/Ω 16.6 |
| DC-Netzspannung veränderlich: $U_{n1}$ = 300 V, $U_{n2}$ = 500 V | | | | | |
| $U_{n1}$/V 300 | $U_{g1}$/V 50 | $I_{m1}$/mA 1.098 | $U_{n2}$/V 500 | $U_{g2}$/V -50 | $I_{m2}$/mA 0.854 |
| K 2.43977E-06 | $I_{g1}$/mA 0.36567 | $R_{f1}$/Ω 16.7 | ODER | $I_{g2}$/mA -0.3657 | $R_{f2}$/Ω 16.7 |

Es zeigt sich, dass bei veränderlicher DC-Netzspannung $U_n$ nach einem Sprung der DC-Netzspannung $U_n$ von $U_{n1}$=300 V auf $U_{n2}$=500 V bei t=3 s der Isolationswiderstand $R_f$ (mit der Differenz von 0.1 Ω nahezu) korrekt bestimmt werden kann.

Die Berechnung kann dabei sowohl für den ersten Messzeitpunkt t=2 s (linksseitig) in eingeschwungenem Zustand der ersten Pulsamplitude $U_{g1}$ als auch für den zweiten Messzeitpunkt t=4 s in eingeschwungenem Zustand der zweiten Pulsamplitude $U_{g2}$ durchgeführt werden.

**Patentansprüche**

1. Verfahren zur Berechnung eines Isolationswiderstands ($R_f$) in einem ungeerdeten DC-Stromversorgungssystem (2) bei veränderlicher DC-Netzspannung ($U_{n1}$, $U_{n2}$), wobei zwischen jeweils einem der aktiven Leiter ($L_+$, $L_-$) des DC-Stromversorgungssystems (2) gegen Erde (PE) ein Messpfad (4) eingerichtet ist, der eine Reihenschaltung mit einem Ankoppelwiderstand ($R_{a+}$, $R_{a-}$), einem Messwiderstand ($R_{m+}$, $R_{m-}$) und einem Messspannungsgenerator (6) zum Erzeugen einer Messpulsspannung ($U_g$) aufweist,
umfassend die Verfahrensschritte:

   Schalten einer periodischen Rechteck-Messpulsspannung ($U_g$) mit einer ersten Pulsamplitude ($U_{g1}$) und einer zweiten Pulsamplitude ($U_{g2}$),
   Messen eines ersten Gesamtmessstroms ($I_{m1}$) in eingeschwungenem Zustand der ersten Pulsamplitude ($U_{g1}$) bei aktueller erster DC-Netzspannung ($U_{n1}$),
   Messen eines zweiten Gesamtmessstroms ($I_{m2}$) in eingeschwungenem Zustand der zweiten Pulsamplitude ($U_{g2}$) bei aktueller zweiter DC-Netzspannung ($U_{n2}$),
   Berechnen eines Korrekturfaktors (K) aus der ersten Pulsamplitude ($U_{g1}$) und der zweiten Pulsamplitude ($U_{g2}$), dem ersten Gesamtmessstrom ($I_{m1}$) und dem zweiten Gesamtmessstrom ($I_{m2}$) und der aktuellen ersten DC-Netzspannung ($U_{n1}$) und der zweiten DC-Netzspannung ($U_{n2}$),
   Berechnen eines von der ersten Pulsamplitude ($U_{g1}$) getriebenen ersten Messpulsstroms ($I_{g1}$) aus der Differenz des gemessenen ersten Gesamtmessstroms ($I_{m1}$) und der mit dem Korrekturfaktor (K) multiplizierten aktuellen ersten DC-Netzspannung ($U_{n1}$) oder
   Berechnen eines von der zweiten Pulsamplitude ($U_{g2}$) getriebenen zweiten Messpulsstroms ($I_{g2}$) aus der Differenz des gemessenen zweiten Gesamtmessstroms ($I_{m2}$) und der mit dem Korrekturfaktor (K) multiplizierten aktuellen zweiten DC-Netzspannung ($U_{n2}$),
   Berechnen des Isolationswiderstands ($R_f$) aus der ersten Pulsamplitude ($U_{g1}$), dem ersten Messpulsstrom ($I_{g1}$) den Ankoppelwiderständen ($R_{a+}$, $R_{a-}$) und den Messwiderständen ($R_{m+}$, $R_{m-}$) oder
   Berechnen des Isolationswiderstands ($R_f$) aus der zweiten Pulsamplitude ($U_{g2}$), dem zweiten Messpulsstrom ($I_{g2}$), den Ankoppelwiderständen und den Messwiderständen ($R_{m+}$, $R_{m-}$).

2. Verfahren nach Anspruch 1,
**dadurch gekennzeichnet,**
**dass** der Korrekturfaktor (K) mit folgenden Verfahrensschritten bestimmt wird:

   Berechnen einer Stromdifferenz ($I_d$) aus dem mit dem Verhältnis ($U_{g2}/U_{g1}$) der zweiten Pulsamplitude ($U_{g2}$) zu der ersten Pulsamplitude ($U_{g1}$) multiplizierten ersten Gesamtmessstrom ($I_{m1}$) und dem zweiten Gesamtmessstrom (Im2),
   Berechnen einer Spannungsdifferenz ($U_d$) aus der mit dem Verhältnis der zweiten Pulsamplitude ($U_{g2}$) zu der ersten Pulsamplitude ($U_{g1}$) multiplizierten aktuellen ersten DC-Netzspannung $U_{n1}$) und der zweiten DC-Netzspannung ($U_{n2}$) und
   Berechnen des Korrekturfaktors (K) als Quotient ($I_d/U_d$) aus der Stromdifferenz ($I_d$) und der Spannungsdifferenz ($U_d$).

3. Verfahren nach Anspruch 1 oder 2,
**dadurch gekennzeichnet,**
**dass** der Isolationswiderstand ($R_f$) in folgenden Verfahrensschritten berechnet wird:

   Berechnen eines Widerstands-Quotienten ($U_{g1}/I_{g1}$, $U_{g2}/I_{g2}$) aus der ersten oder der zweiten Pulsamplitude ($U_{g1}$, $U_{g2}$) und dem entsprechenden ersten oder zweiten Messpulsstrom ($I_{g1}$, $I_{g2}$),
   Berechnen einer Widerstands-Differenz als Isolationswiderstand ($R_f$, $R_{f1}$, $R_{f2}$) aus der Differenz des Widerstands-Quotienten ($U_{g1}/I_{g1}$, $U_{g2}/I_{g2}$) und einem Messpfad-Widerstand ($R_a/2$),
   wobei sich der Messpfad-Widerstand ($R_a/2$) aus der Parallelschaltung der Reihenschaltungen ($R_{a+}+ R_{m+}$, $R_{a-}+ R_{m-}$) des Ankoppelwiderstands ($R_{a+}$, $R_{a-}$) und des Messwiderstands ($R_{m+}$, $R_{m-}$) ergibt.

**4.** Verfahren nach Anspruch 3,
**dadurch gekennzeichnet,**
**dass** ein Vergleich des aus der ersten Messung ($U_{g1}$, $I_{g1}$) berechneten Isolationswiderstands ($R_{f1}$) mit dem aus der zweiten Messung ($U_{g2}$, $I_{g2}$) berechneten Isolationswiderstand ($R_{f2}$) durchgeführt wird.

**Claims**

**1.** A method for computing an insulation resistance ($R_f$) in an ungrounded DC power supply system (2) at a changeable DC line voltage ($U_{n1}$, $U_{n2}$), a measuring path (4) being installed between each active conductor (L+, L-) of the DC power supply system (2) to ground (PE), the measuring path (4) having a series connection having a coupling resistance ($R_{a+}$, $R_{a-}$), a measuring resistance ($R_{m+}$, $R_{m-}$) and a measuring-voltage generator (6) for generating a measuring pulse voltage ($U_g$),
the method comprising the following steps:

switching a periodic square measuring pulse voltage ($U_g$) having a first pulse amplitude ($U_{g1}$) and a second pulse amplitude ($U_{g2}$),
measuring a first total measuring current ($I_{m1}$) in a settled state of the first pulse amplitude ($U_{g1}$) at a current first DC line voltage ($U_{n1}$),
measuring a second total measuring current ($I_{m2}$) in a settled state of the second pulse amplitude ($U_{g2}$) at a current second DC line voltage ($U_{n2}$),
computing a correction factor (K) from the first pulse amplitude ($U_{g1}$) and the second pulse amplitude ($U_{g2}$), the first total measuring current ($I_{m1}$) and the second total measuring current ($I_{m2}$) and the current first DC line voltage ($U_{n1}$) and the second DC line voltage ($U_{n2}$)
computing a first measuring pulse current ($I_{g1}$) driven by the first pulse amplitude ($U_{g1}$) from the difference of the measured first total measuring current ($I_{m1}$) and the current first DC line voltage ($U_{n1}$) multiplied by the correction factor (K), or
computing a second measuring pulse current ($I_{g2}$) driven by the second pulse amplitude ($U_{g2}$) from the difference of the measured second total measuring current ($I_{m2}$) and the current second DC line voltage ($U_{n2}$) multiplied by the correction factor (K),
computing the insulation resistance ($R_f$) from the first pulse amplitude ($U_{g1}$), the first measuring pulse current ($I_{g1}$), the coupling resistances ($R_{a+}$, $R_{a-}$) and the measuring resistances ($R_{m+}$, $R_{m-}$), or
computing the insulation resistance ($R_f$) from the second pulse amplitude ($U_{g2}$), the second measuring pulse current ($I_{g2}$), the coupling resistances ($R_{a+}$, $R_{a-}$) and the measuring resistances ($R_{m+}$, $R_{m-}$).

**2.** The method according to claim 1,
**characterized in that**
the correction factor (K) is determined using the following method steps:

computing a current difference ($I_d$) from the first total measuring current ($I_{m1}$) multiplied by the ratio ($U_{g2}/U_{g1}$) of the second pulse amplitude ($U_{g2}$) to the first pulse amplitude ($U_{g1}$) and from the second total measuring current ($I_{m2}$),
computing a voltage difference ($U_d$) from the current first DC line voltage ($U_{n1}$) multiplied by the ratio of the second pulse amplitude ($U_{g2}$) to the first pulse amplitude ($U_{g1}$) and from the second line voltage ($U_{n2}$), and
computing the correction factor (K) as a quotient ($I_d/U_d$) from the current difference ($I_d$) and the voltage difference ($U_d$).

**3.** The method according to claim 1 or 2,
**characterized in that**
the insulation resistance ($R_f$) is computed in the following steps:

computing a resistance quotient ($U_{g1}/I_{g1}$, $U_{g2}/I_{g2}$) from the first or the second pulse amplitude ($U_{g1}$, $U_{g2}$) and the respective first or second measuring pulse current ($I_{g1}$, $I_{g2}$),
computing a resistance difference as an insulation resistance ($R_f$, $R_{f1}$, $R_{f2}$) from the difference of the resistance quotient ($U_{g1}/I_{g1}$) and a measuring path resistance ($R_a/2$),
the measuring path resistance ($R_a/2$) resulting from the parallel connection of the series connections ($R_{a+}$, $R_{m+}$, $R_{a-}$, $R_{m-}$) of the coupling resistance ($R_{a+}$, $R_{a-}$) and the measuring resistance ($R_{m+}$, $R_{m-}$).

**4.** The method according to claim 3,
**characterized in that**
the insulation resistance ($R_{f1}$) computed from the first measurement ($U_{g1}$, $I_{g1}$) is compared to the insulation resistance ($R_{f2}$) computed from the second measurement ($U_{g2}$, $I_{g2}$).

**Revendications**

**1.** Procédé pour calculer une résistance d'isolement ($R_f$) dans un système (2) d'alimentation en courant continu non mis à la terre à une tension de réseau ($U_{n1}$, $U_{n2}$) continu variable, une voie de mesure (4) étant installée entre chaque conducteur actif (L+, L-) du système (2) d'alimentation en courant continu et la terre (PE), la voie de mesure (4) ayant un montage en série avec une résistance de couplage ($R_{a+}$, $R_{a-}$), une résistance de mesure ($R_{m+}$, $R_{m-}$) et un générateur (6) de tension de mesure pour générer une tension ($U_g$) d'impulsion de mesure,
le procédé comprenant les étapes suivantes :

la commutation d'une tension ($U_g$) d'impulsion de mesure carrée périodique ayant une première amplitude d'impulsion ($U_{g1}$) et une deuxième amplitude d'impulsion ($U_{g2}$),
la mesure d'un premier courant de mesure ($I_{m1}$) total au régime permanent de la première amplitude d'impulsion ($U_{g1}$) à une première tension continue de réseau ($U_{n1}$) actuelle,
la mesure d'un deuxième courant de mesure ($I_{m2}$) total au régime permanent de la deuxième amplitude d'impulsion ($U_{g2}$) à une deuxième tension de réseau continue ($U_{n2}$) actuelle,
le calcul d'un facteur de correction (K) à partir de la première amplitude d'impulsion ($U_{g1}$) et de la deuxième amplitude d'impulsion ($U_{g2}$), du premier courant de mesure ($I_{m1}$) total et du deuxième courant de mesure ($I_{m2}$) total et de la première tension continue de réseau ($U_{n1}$) actuelle et de la deuxième tension continue de réseau ($U_{n2}$) actuelle,
le calcul d'un premier courant ($I_{g1}$) d'impulsion de mesure entraîné par la première amplitude d'impulsion ($U_{g1}$) à partir de la différence entre le premier courant de mesure ($I_{m1}$) total mesuré et la première tension continue de réseau ($U_{n1}$) actuelle multipliée par le facteur de correction (K), ou
le calcul d'un deuxième courant ($I_{g2}$) d'impulsion de mesure entraîné par la deuxième amplitude d'impulsion ($U_{g2}$) à partir de la différence entre le deuxième courant de mesure ($I_{m2}$) total mesuré et la deuxième tension continue de réseau ($U_{n2}$) actuelle multipliée par le facteur de correction (K),
le calcul de la résistance d'isolement ($R_f$) à partir de la première amplitude d'impulsion ($U_{g1}$), du premier courant ($I_{g1}$) d'impulsion de mesure, des résistances de couplage ($R_{a+}$, $R_{a-}$) et des résistances de mesure ($R_{m+}$, $R_{m-}$), ou
le calcul de la résistance d'isolement ($R_f$) à partir de la deuxième amplitude d'impulsion ($U_{g2}$), du deuxième courant ($I_{g2}$) d'impulsion de mesure, des résistances de couplage ($R_{a+}$, $R_{a-}$) et des résistances de mesure ($R_{m+}$, $R_{m-}$).

**2.** Procédé selon la revendication 1,
**caractérisé en ce que**
le facteur de correction (K) est déterminé en utilisant les étapes de procédé suivantes :

le calcul d'une différence de courant ($I_d$) à partir du premier courant de mesure ($I_{m1}$) total multiplié par le rapport ($U_{g2}/U_{g1}$) de la deuxième amplitude d'impulsion ($U_{g2}$) à la première amplitude d'impulsion ($U_{g1}$) et à partir du deuxième courant de mesure ($I_{m2}$) total,
le calcul d'une différence de tension ($U_d$) à partir de la première tension continue de réseau ($U_{n1}$) actuelle multipliée par le rapport de la deuxième amplitude d'impulsion ($U_{g2}$) à la première amplitude d'impulsion ($U_{g1}$) et à partir de la deuxième tension continue de réseau ($U_{n2}$), et
le calcul du facteur de correction (K) comme un quotient ($I_d/U_d$) à partir de la différence de courant ($I_d$) et de la différence de tension ($U_d$).

**3.** Procédé selon la revendication 1 ou la revendication 2,
**caractérisé en ce que**
la résistance d'isolement ($R_f$) est calculée dans les étapes suivantes :

le calcul d'un quotient de résistance ($U_{g1}/I_{g1}$, $U_{g2}/I_{g2}$) à partir de la première ou de la deuxième amplitude d'impulsion ($U_{g1}$, $U_{g2}$) et du premier ou du deuxième courant ($I_{g1}$, $I_{g2}$) d'impulsion de mesure respectif,
le calcul d'une différence de résistance comme une résistance d'isolement ($R_f$, $R_{f1}$, $R_{f2}$) à partir de la différence entre le quotient de résistance ($U_{g1}/I_{g1}$) et une résistance ($R_a/2$) de voie de mesure,

la résistance ($R_a$/2) de voie de mesure résultant du montage en parallèle du montage en séries ($R_{a+}$+, $R_{m+}$, $R_a$-+, $R_{(m)-}$) de la résistance de couplage ($R_{a+}$, $R_{(a)-}$) et de la résistance de mesure ($R_{m+}$, $R_{(m)-}$) .

4. Procédé selon la revendication 3,
   **caractérisé en ce que**
   la résistance d'isolement ($R_{f1}$) calculée à partir de la première mesure ($U_{g1}$, $I_{g1}$) est comparée à la résistance d'isolement ($R_{f2}$) calculée à partir de la deuxième mesure ($U_{g2}$, $I_{g2}$).

**Fig. 1**

**Fig. 2**

**Fig. 3**

EP 4 484 971 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102014205877 A1
- DE 102014204870 A1
- US 2018154776 A1